**Europäisches Patentamt**

**European Patent Office**

**Office européen des brevets**

(19)

(11) Numéro de publication : **0 466 527 A2**

# (12) DEMANDE DE BREVET EUROPEEN

(21) Numéro de dépôt : **91401449.3**

(22) Date de dépôt : **04.06.91**

(51) Int. Cl.⁵ : **H01L 21/28, H01L 21/338, H01L 21/027**

(30) Priorité : **12.06.90 FR 9007280**

(43) Date de publication de la demande :
**15.01.92 Bulletin 92/03**

(84) Etats contractants désignés :
**DE GB NL**

(71) Demandeur : **THOMSON COMPOSANTS MICROONDES**
**51, Esplanade du Général de Gaulle**
**F-92800 Puteaux (FR)**

(72) Inventeur : **Pham Ngu, Tung**
**THOMSON-CSF, SCPI, Cédex 67**
**F-92045 Paris la Défense (FR)**
Inventeur : **Chapuis, Martine**
**THOMSON-CSF, SCPI, Cédex 67**
**F-92045 Paris la Défense (FR)**

(74) Mandataire : **Taboureau, James**
**THOMSON-CSF SCPI**
**F-92045 Paris La Défense Cédex 67 (FR)**

(54) **Procédé de réalisation d'une grille de transistor.**

(57)     L'invention concerne un procédé pour la réalisation d'une grille "champignon" de transistor hyperfréquence.

Sur le corps semiconducteur d'un transistor (1) sont déposées trois couches (9, 10, 11) de masquage, dont au moins deux sont différentes (10,11) et ont des solvants sélectifs. Après ouverture (12) de la couche externe (11), la couche intermédiaire (10) est dissoute avec sous-gravure par rapport à la couche externe (11), puis le pied de la grille est gravé (17) dans la couche interne (9). Les bords (15,16) de la sous-gravure évitent que le métal (19, 20) déposé sur le masque n'adhère à la grille (18), ce qui facilite la dissolution (lift-off) du masque.

Application aux transistors hyperfréquence, avec grille champignon symétrique ou dissymétrique.

FIG.7

EP 0 466 527 A2

La présente invention concerne un procédé de fabrication des grilles de transistors à effet de champ, plus particulièrement dédié aux transistors hyperfréquences, pour lesquels la grille doit être mince à sa base, mais comporte un tablier ou casquette qui en diminue la résistance électrique : ces grilles sont connues sous l'appellation de grilles champignons (mushroom gates).

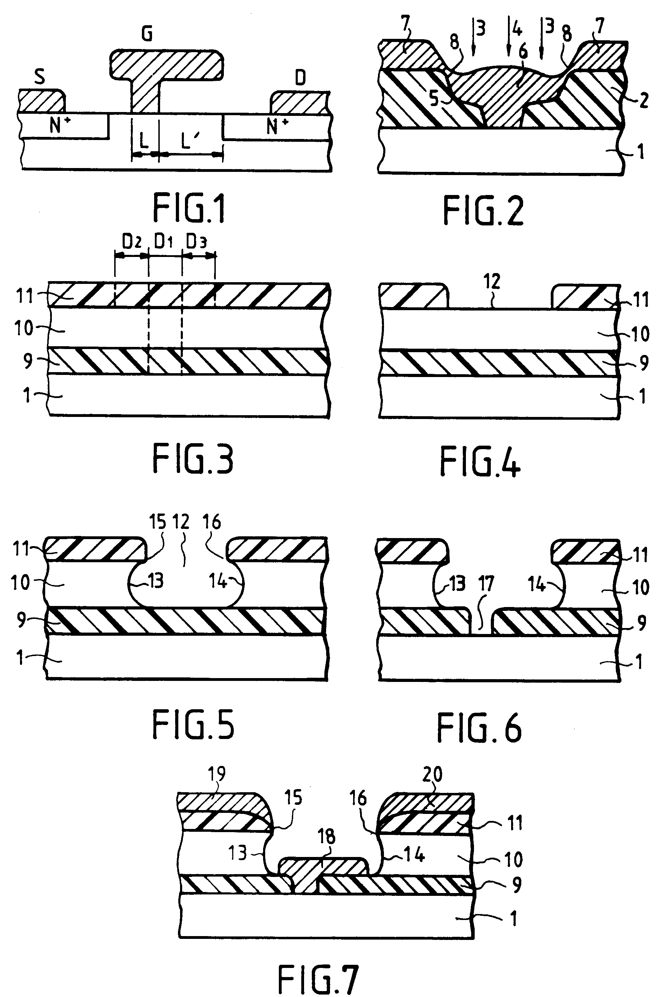

Les performances d'un transistor hyperfréquence à effet de champ, tel que schématisé en figure 1, dépendent d'une part de la longueur L de la grille G, mesurée selon l'axe source S/drain D, qui doit être d'autant plus petite que la fréquence est élevée, mais aussi d'autre part de la résistance électrique de la grille, qui est d'autant plus élevée que la grille est plus fine. La recherche de faibles résistances d'accès est permanente dans l'étude des transistors.

Pour ces raisons ont été développées des métallisations de grilles en forme de champignons, avec un pied de faible largeur - micronique ou submicronique - et un tablier ou casquette plus large, et rechargé en métal pour réduire la résistance électrique.

Mais les performances d'un transistor hyperfréquence en général, et celles d'un transistor hyperfréquence de puissance en particulier, sont améliorées en augmentant la distance l'entre la grille G et la zone dopée $n^+$ contrôlée par le drain D : cela réduit la capacité parasite grille/drain $C_{GD}$ et augmente la tension de claquage du transistor.

Une telle structure dissymétrique est montrée en figure 1. Selon que le transistor comprend une tranchée, ou recess, pour la grille, ou est autoaligné, cette dissymétrie de position de la grille peut être obtenue par différents artifices, parmi lesquels le dépôt de la grille sous une légère inclinaison, ou bien un masquage supplémentaire pour éloigner la zone implantée $n^+$ dissymétrique des deux caissons de source et drain.

Cependant, que la grille champignon soit ou ne soit pas dissymétrique, sa fabrication elle-même reste une opération délicate pour la raison suivante, schématisée en figure 2 : le procédé le plus courant consiste à déposer, sur une plaquette 1 de matériaux semiconducteurs - comprenant le substrat et les différentes couches constitutives d'un transistor - une épaisse couche 2 de résine de masquage. Au moyen d'un faisceau approprié, électrons ou rayons X, on définit par un premier balayage 3 le tablier de la grille sur une partie de l'épaisseur de la résine 2, puis par un second balayage 4 plus énergétique le pied de la grille, sur toute l'épaisseur de la résine 2. Les différentes doses peuvent être obtenues soit en modifiant l'énergie du faisceau, soit en effectuant plusieurs passes pour le second balayage 4. Après dissolution de la résine irradiée, il reste une empreinte dans laquelle est projeté le métal de la grille champignon 6, épaissie par voie électrolytique. Le métal se dépose également en 7 sur la face supérieure de la couche de résine 2, et forme en 8 de fines membranes qui jouxtent les métallisations 6 et 7.

L'inconvénient de ce procédé vient de ce que, lorsque la résine 2 est dissoute au cours d'une opération dite de "lift-off", la pellicule métallique 7 reste soudée sur la grille 6 par les membranes 8, parce que l'implantation et la dissolution d'une unique résine de masquage ne peuvent pas fournir un profil d'empreinte 5 tel qu'il y ait rupture nette du profil entre la face supérieure de la résine 2 et les parois latérales de l'empreinte 5. Les arrondis dus à la dissolution font qu'en 8 le métal de la pellicule 7 descend dans l'empreinte 5, de façon continue avec la grille 6.

Le procédé selon l'invention permet de supprimer cet inconvénient. Il prévoit, pour la réalisation d'une grille champignon, l'utilisation de trois couches superposées de masquage, choisies parmi au moins deux produits, organiques et/ou minéraux, qui jouissent d'une grande sélectivité de dissolution ; à chaque produit correspond au moins un solvant qui n'attaque pas l'autre produit, et réciproquement. Ceci permet de mener une attaque sélective pour chaque couche de masquage, et en particulier d'effectuer une sous-gravure de la couche centrale, de sorte que la couche supérieure vienne en surplomb. La présence de ce surplomb interrompt la continuité entre le métal déposé dans l'empreinte pour former la grille et le métal déposé sur la face externe de la couche supérieure.

De façon plus précise, l'invention concerne un procédé de réalisation d'une grille de transistor, ladite grille ayant une forme dite "champignon" et comportant un pied étroit et un tablier plus large que le pied, ce procédé étant caractérisé en ce que l'on utilise trois couches de masquage, la couche intermédiaire étant de nature différente des première et troisième couches, et de plus soluble dans un solvant sélectif qui n'est pas solvant des première et troisième couches, de sorte que la couche intermédiaire peut être sous-gravée par rapport à la troisième couche, extérieure par rapport au corps du transistor.

L'invention sera mieux comprise par l'exposé détaillé d'un exemple de réalisation, en liaison avec les figures jointes qui représentent :

– figure 1 : vue en coupe d'un transistor selon l'art connu, exposée précédemment,

– figure 2 : schéma de fabrication d'une grille champignon selon l'art connu, exposée précédemment,

– figures 3 à 7 : étapes de fabrication d'une grille champignon selon l'invention.

La première étape du procédé, illustrée en figure 3, suppose que le corps 1 du transistor est déjà formé : il comprend un substrat, les couches de lissage, les couches actives avec ou sans hétérojonctions, éventuellement les caissons dopés de prises de contacts des électrodes. La face supérieure de ce corps 1 est ici représentée plane, mais elle peut comporter un sillon, en recess, dans la région de la future grille.

Sur ce corps 1 sont déposées trois couches de masquage 9, 10 et 11. La première couche 9, au contact du corps semiconducteur 1, est constituée par exemple par une première résine de masquage, de préférence électrosensible car si le pied de la grille doit être submicronique, l'irradiation par électrons ou rayons X est plus précise que l'exposition photonique. Cette résine est par exemple un polyméthyl méthacrylate, et elle est déposée sous une épaisseur de l'ordre de 3000 angströms.

La seconde couche 10, intermédiaire, est formée soit par une seconde résine de masquage, de nature différente de la première résine, soit par un produit minéral, tel que la silice par exemple : le point important est que la couche intermédiaire 10 soit soluble de façon sélective par rapport aux deux autres couches. Si c'est une résine de masquage, ce peut être un polyméthyl glutamate, ou poly (diméthyl glutarimide) sous une épaisseur de l'ordre de 7000 angströms.

La troisième couche 11, en surface, peut être de même nature que la première couche 9. Elle a une épaisseur également de l'ordre de 3000 angströms.

A l'emplacement de la future grille, les trois couches sont alors soumises à un masquage électronique sélectif. Le pied de la grille, de longueur D1, qui se trouvera dans l'épaisseur de la première couche 9, est soumis à un bombardement électronique suffisamment énergétique pour atteindre la surface du corps semiconducteur 1 : par exemple 5 balayages de largeur D1. Le tablier, ou champignon, de la grille se trouvera dans l'épaisseur de la deuxième couche 10 et aura une longueur D1 + D2 + D3 égale à celle du pied plus celles, symétriques ou non, des deux casquettes. Pour définir ce tablier, la troisième couche 11 est soumise à un masquage électronique avec une dose beaucoup plus faible, juste suffisante pour sensibiliser la couche superficielle 11, ce qui entraînera d'ailleurs un temps de développement beaucoup plus long : on ne fait par exemple qu'un seul balayage de longueur D1 + D2 + D3.

L'ordre des deux masquages peut être inversé sans inconvénient pour le procédé.

La couche intermédiaire 10 ne se trouve de ce fait pas soumise à un bombardement électronique, sauf dans sa partie de longueur D1 correspondant au pied de la grille, et légèrement à son interface avec la troisième couche 11. Elle sera ultérieurement gravée par dissolution sélective à travers l'ouverture de la troisième couche 11.

Les opérations suivantes concernent le développement sélectif des trois couches de masquage.

La couche superficielle 11 est d'abord développée par un solvant qui ne dissout pas la couche intermédiaire 10 : on obtient une ouverture 12, montrée en figure 4. Si la couche superficielle 11 est en polyméthyl méthacrylate, son solvant sélectif est un mélange de Propanol et de Méthyl Ethyl Cétone à 35 % en volume, et le développement dure 2 minutes, à température 22°C.

Par l'ouverture 12, la couche intermédiaire 10 est gravée par un solvant qui ne dissout pas la couche superficielle 11 ni la couche enterrée 9. Si la couche 10 est en polyméthyl glutamate, ce solvant sélectif est une solution aqueuse basique, de soude, par exemple. Le développement de la couche 10 dure environ 2 minutes.

L'intérêt de ces développements sélectifs est que, comme le montre la figure 5, il permet de prolonger la dissolution de la couche intermédiaire 10 un temps suffisant pour obtenir une sous-gravure, en 13 et 14, sous la troisième couche 11. Ainsi, les bords de l'ouverture 12 forment des surplombs en 15 et 16, qui rompent la continuité des surfaces latérales de l'empreinte gravée dans les couches de masquage, et ces surplombs 15 et 16 empêcheront ultérieurement la formation d'un film continu métallique, tel que représenté en 8 sur la figure 2.

Enfin, en figure 6, le pied de la grille est gravé en 17, par développement pendant 30 secondes de la partie irradiée, de longueur D1, dans la première couche 9. Il est avantageux que la première et la troisième couches 9 et 11 soient en même résine, et aient même solvant sélectif par rapport à la deuxième couche 10. Si une troisième résine, différente des autres, doit être utilisée pour définir le pied de la grille, parce qu'elle autorise une gravure plus fine, il faut alors choisir un troisième solvant sélectif qui ne dissolve ni la deuxième ni la troisième couches 10 et 11.

C'est pourquoi il est intéressant d'utiliser la silice pour former la deuxième couche 10. On a alors :

– une première couche 9, organique, dissoute par un premier solvant organique, ou une solution minérale

– une deuxième couche 10, minérale, dissoute par une solution minérale

– une troisième couche 11, organique, mais différente éventuellement de la première couche 9, et dissoute par un second solvant organique, ou une solution aqueuse basique.

Ceci permet de jouer sur la précision de gravure des couches et sur leur sensibilité au masquage électronique, tout en se réservant la possibilité de sousgraver la couche intermédiaire.

L'opération de métallisation de la grille, en figure 7, est conventionnelle pour ce type de procédé. Le métal ou l'alliage de métaux, pour faire une grille à contact Schottky ou ohmique, est évaporé par un procédé directif. Il se dépose dans le fond de l'empreinte pour faire une grille 18, mais aussi en 19 et 20 sur la troisième couche de masquage. Cependant, les surplombs 15 et 16 dans cette couche servent à la fois à autoaligner la grille 18, et à séparer de la grille 18 la pellicule métallique qui est au niveau de la troisième couche.

Ceci facilite le lift-off final qui élimine la pellicule métallique 19-20 et les couches 9,10,11 de masquage. La grille 18, dont le pied est très fin pour les hyperfréquences, peut être rechargée en métal, par électrolyse, pour diminuer sa résistance électrique.

Les deux casquettes de la grille serviront éventuellement à auto-aligner les régions $n^+$ et métallisations de source et de drain d'un transistor qui est soit à faible bruit, soit de puissance.

## Revendications

**1 -** Procédé de réalisation d'une grille de transistor, ladite grille ayant une forme dite "champignon" et comportant un pied étroit et un tablier plus large que le pied, ce procédé étant caractérisé en ce que l'on utilise trois couches de masquage (9, 10, 11), la couche intermédiaire (10) étant de nature différente des première (9) et troisième (11) couches, et de plus soluble dans un solvant sélectif qui n'est pas solvant des première (9) et troisième (11) couches, de sorte que la couche intermédiaire (10) peut être sous-gravée par rapport à la troisième couche (11), extérieure par rapport au corps (1) du transistor.

**2 -** Procédé selon la revendication 1, caractérisé en ce que les trois couches de masquage (9,10,11) sont des couches organiques choisies parmi au moins deux résines différentes, et ayant au moins deux solvants sélectifs, la couche intermédiaire (10) étant différente des première (9) et troisième (11) couches.

**3 -** Procédé selon la revendication 1, caractérisé en ce que l'une (10) au moins parmi les trois couches (9,10,11) est minérale, en silice, les autres couches (9,11) étant organiques.

**4 -** Procédé selon la revendication 1, caractérisé en ce qu'il comporte les étapes suivantes :

a) sur un corps semiconducteur (1), déposer trois couches de masquage (9, 10, 11), superposées, constituées par au moins deux matériaux ayant des solvants sélectifs, la couche intermédiaire (10) étant différente des première (9) et troisième (11) couches,

b) exposer à un rayonnement électronique la troisième couche (11) sur une longueur ($D_1 + D_2 + D_3$) égale à celle du tablier de la grille à réaliser, la dose mise en jeu étant limitée pour n'agir que sur l'épaisseur de la troisième couche (11)

c) exposer à un rayonnement électronique la première couche (9) sur une longueur ($D_1$) égale à celle du pied de la grille

d) au moyen d'un premier solvant sélectif, ouvrir une fenêtre (12) dans la troisième couche (11)

e) au moyen d'un second solvant sélectif, dissoudre la couche intermédiaire (10) avec effet de sous - gravure (13, 14) sous les bords (15, 16) de la fenêtre (12) dans la troisième couche (11)

f) au moyen d'un troisième solvant sélectif, dissoudre la première couche (9) à l'endroit (17) du pied de la grille,

g) projeter une métallisation, pour réaliser la grille (18) du transistor,

h) dissoudre les couches de masquage (9,10,11), ce qui élimine les métaux déposés (19,20) sur la troisième couche (11) de masquage.

FIG.1

FIG.2

FIG.3

FIG.4

FIG.5

FIG.6

FIG.7